# EUROPEAN PATENT APPLICATION

(11) **EP 2 383 791 A2**
(43) Date of publication of application: **02.11.2011**
(21) Application number: 11003429.5
(22) Date of filing: 26.04.2011
(51) Int. Cl.: H01L 31/0224

(54) **Solar cell**

(30) Priority: 29.04.2010 KR 20100040060
(71) Applicant: LG ELECTRONICS INC., Yeongdeungpo-gu Seoul 150-721 (KR)
(72) Inventor: Jang, Daehee, Seocho-Gu Seoul, 137-724 (KR); Kim, Jonghwan, Seocho-Gu Seoul, 137-724 (KR); Lee, Giwon, Seocho-Gu Seoul, 137-724 (KR); Kang, Juwan, Seocho-Gu Seoul, 137-724 (KR); Lee, Kyoungsoo, Seocho-Gu Seoul, 137-724 (KR); Ha, Manhyo, Seocho-Gu Seoul, 137-724 (KR)
(74) Representative: Katérle, Axel

(57) **Abstract**

A solar cell is discussed. The solar cell includes a substrate of a first conductive type; a first emitter region of a second conductive type opposite the first conductive type and forming a p-n junction with the substrate; a front electrode unit on a first surface of the substrate, and connected to the first emitter region; a back surface field region of the first conductive type formed at a second surface of the substrate opposite the first surface, and having a lattice shape with a plurality of internal portions; a rear passivation layer unit formed on the second surface, and a rear electrode electrically connected to the substrate.

## Description

### BACKGROUND OF THE INVENTION

### Field of the Invention

Embodiments of the invention relate to a solar cell.

### Description of the Related Art

Recently, as existing energy sources such as petroleum and coal are expected to be depleted, interests in alternative energy sources for replacing the existing energy sources are increasing. Among the alternative energy sources, solar cells generating electric energy from solar energy have been particularly spotlighted.

A solar cell generally includes semiconductor portions of different conductive types from each other forming a p-n junction, the different conductive types being a p-type and an n-type, and electrodes connected to the semiconductor portions, respectively.

When light is incident on the solar cell, a plurality of electron-hole pairs are generated in the semiconductor portions. The electron-hole pairs are separated into electrons and holes by the photovoltaic effect. Thus, the separated electrons move to the n-type semiconductor portion and the separated holes move to the p-type semiconductor portion, The electrons and holes are respectively collected by the electrode electrically connected to the n-type semiconductor portion and the electrode electrically connected to the p-type semiconductor portion. The electrodes are connected to one another using electric wires to thereby obtain electric power.

### SUMMARY OF THE INVENTION

According to an aspect of the invention, a solar cell may include a substrate of a first conductive type, a first emitter region of a second conductive type opposite the first conductive type and forming a p-n junction with the substrate, a front electrode unit on a first surface of the substrate and connected to the first emitter region, a back surface field region of the first conductive type formed at a second surface of the substrate opposite the first surface, and having a lattice shape with a plurality of internal portions, a rear passivation layer unit formed on the second surface, and a rear electrode electrically connected to the substrate.

One or more of the plurality of internal portions may be doped with impurities of the first type so that the one or more of the plurality of internal portions may be a part of the back surface field region.

The back surface field region may be formed on substantially the entire second surface of the substrate.

The rear electrode may be formed of at least one stripe shape or in a lattice pattern.

The solar cell according to the aspect may further include at least one rear electrode charge collector, and the at least one rear electrode charge collector may be made of a different material from the rear electrode.

The at least one rear electrode charge collector may be formed over the rear electrode.

The lattice shape of the back surface field region may include a plurality of first portions having first widths and a plurality of second portions having second width that is greater than the first widths.

The solar cell according to the aspect may further includes a plurality of rear electrode charge collectors extending in a direction on the second surface of the substrate and connected to the back surface field region.

The rear electrode may be directly in contact with the plurality of first portions of the back surface field region, and the plurality of rear electrode charge collectors may be directly in contact with the plurality of second portions of the back surface field region.

The rear electrode may be connected to the back surface field region through the rear passivation layer unit.

The solar cell according to the aspect may further include a reflection layer positioned on the second surface of the substrate.

The reflection layer may contain aluminum.

The reflection layer may be made of an insulating material.

The reflection layer may be positioned on the rear passivation layer unit positioned between adjacent portions of the rear electrode.

The reflection layer may be positioned on the rear electrode and the rear passivation layer unit.

The rear passivation layer unit may include a plurality of openings exposing portions of the second surface of the substrate on which the back surface field region is positioned.

A size of the second surface of the substrate exposed through the plurality of openings may be about 0.5% to 30% of an entire second surface of the substrate.

The rear electrode may be positioned on the second surface of the substrate exposed through the plurality of openings and the rear passivation layer unit.

The solar cell according to the aspect may further include a plurality of rear electrode charge collectors directly positioned on the second surface of the substrate electrode and connected to the rear electrode.

The solar cell according to the aspect may further include a second emitter region positioned at the second surface of the substrate.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:

FIG. 1 is a perspective view of a portion of a solar cell according to an example embodiment of the invention;

FIG. 2 is a cross-sectional view taken along a line II-II of FIG. 1;

FIGS. 3A to 3C schematically show back surface field regions formed at a rear surface of a solar cell according to example embodiments of the invention;

FIGS. 4A to 4G are sectional views sequentially showing an example of processes for manufacturing a solar cell according to an example embodiment of the invention;

FIGS. 5A to 5G are sectional views sequentially showing another example of processes for manufacturing a solar cell according to an example embodiment of the invention; and

FIG. 5H is a partial cross-sectional view of a portion of a solar cell manufactured according to the processes of FIGS. 5A to 5G;

FIG. 6 is a partial perspective view of a portion of a solar cell according to another example embodiment of the invention;

FIG. 7 is a cross-sectional view taken along a line VII-VII of FIG. 6;

FIG. 8 schematically shows a rear surface of a solar cell according to another example embodiment of the invention;

FIGS. 9A and 9B are sectional views sequentially showing an example of processes for manufacturing a solar cell according to an example embodiment of the invention;

FIG. 10 is a cross-sectional view of a portion of the solar cell when the solar cell is manufactured by another example of processes according to another example embodiment of the invention ;

FIGS. 11 and 12 are partial cross-sectional views of solar cells according to other example embodiments of the invention, respectively;

FIGS. 13 15, 17 and 19 are perspective views of a portion of a solar cell according to other example embodiments of the invention, respectively;

FIGS. 14 and 16, 18 and 20 are cross-sectional views taken along a lines XIV-XIV, XVI-XVI, XVIII-XVIII, and XX-XX of FIGS. 13, 15, 17 and 19, respectively; and

FIG. 21 is a schematic view showing a solar cell module according to example embodiments of the invention.

### DETAILED DESCRIPTION OF THE EMBODIMENTS

The invention will be described more fully hereinafter with reference to the accompanying drawings, in which example embodiments of the inventions are shown. This invention may, however, be embodied in many different forms and should not be construed as limited to only the embodiments set forth herein.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on another element, it may be on the entire surface of the other element and may not be on a portion of an edge of the other element.

Referring to the drawings, a solar cell and a method for manufacturing the solar cell according the example embodiments of the invention will be described.

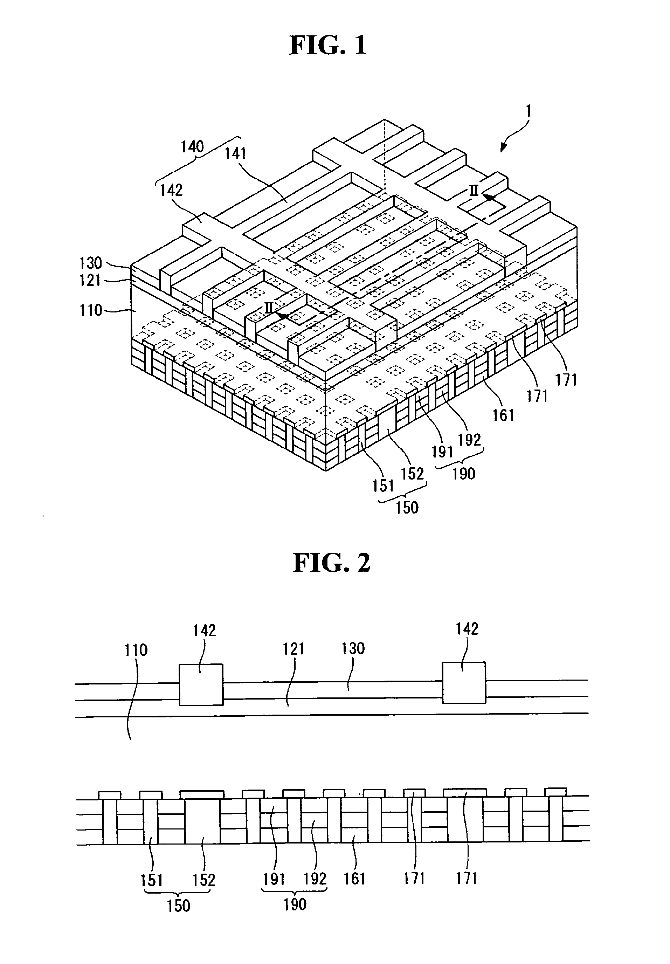

First, referring to FIG. 1 to FIGS. 3A-3C, a solar cell according to an example embodiment of the invention will be described in detail.

Referring to FIGS. 1 and 2, a solar cell 1 according to an example embodiment of the invention includes a substrate 110, an emitter region 121 positioned at a surface (hereinafter, referred to as 'a front surface') of the substrate 110 on which light is incident, an anti-reflection layer 130 on the emitter region 120, a rear passivation layer unit 190 positioned on a surface (a rear surface) of the substrate 110, opposite the front surface of the substrate 110, on which the light is not incident and connected to the substrate 110, a front electrode unit 140 connected to the emitter region 121, a back surface field region 171 locally positioned at the rear surface of the substrate 110, a rear electrode unit 150 connected to the back surface field region 171 and a rear reflection layer 161 positioned on the rear passivation layer unit 190 and connected to adjacent portions of the rear electrode unit 150.

The substrate 110 is a semiconductor substrate containing a first type impurity, for example, a p-type impurity, though not required, and may be made of silicon. In the embodiment, the silicon is polycrystalline silicon, but alternatively, may be single crystal silicon in other embodiments. If the substrate 110 is of the p-type, a group III element impurity such as boron (B), gallium (Ga), and indium (In) is doped in the substrate 110. Alternatively, the substrate 110 may be of an n-type. If the substrate 110 is of the n-type, a group V element impurity such as phosphorus (P), arsenic (As), and antimony (Sb) may be doped in the substrate 110. Alternatively, the substrate 110 may be materials other than silicon. Unlike FIGS. 1 and 2, alternatively, the front surface of the substrate 110 may be etched to form an uneven surface. Hence, a surface area of the substrate 110 increases and a light reflectance of the front surface of the substrate 110 is reduced. Accordingly, a light amount incident to the substrate 110 increases to improve an efficiency of the solar cell 1.

The emitter region 121 is a region of the substrate 110 into which an impurity (e.g., an n-type impurity) of a second conductive type opposite the first conductive type of the substrate 110 is doped. The emitter region 121 is substantially positioned in (at) the entire front surface of the substrate 110, on which light is incident.

The emitter region 121 forms a p-n junction with the substrate 110.

By a built-in potential difference generated due to the p-n junction, a plurality of electron-hole pairs, which are generated by incident light onto the semiconductor substrate 110, are separated into electrons and holes, respectively, and the separated electrons move toward the n-type semiconductor and the separated holes move toward the p-type semiconductor. Thus, when the substrate 110 is of the p-type and the emitter region 121 is of the n-type, the separated holes move toward the substrate 110 and the separated electrons move toward the emitter region 121.

Because the emitter region 121 forms the p-n junction with the substrate 110, when the substrate 110 is of the n-type, then the emitter region 121 will be of the p-type, in contrast to the embodiment discussed above, and the separated electrons will move toward the substrate 110 and the separated holes will move toward the emitter region 121.

Returning to the embodiment when the emitter region 121 is of the n-type, the emitter region 121 may be formed by doping the substrate 110 with the group V element impurity, while when the emitter region 121 is of the p-type, the emitter region 120 may be formed by doping the substrate 110 with the group III element impurity.

The anti-reflection layer 130 positioned on the emitter region 121 has a refractive index of about 1.0 to 2.3. The anti-reflection layer 130 is made of silicon nitride (SiNx), but may be made of other materials such as silicon oxide (SiOx).

The anti-reflection layer 130 reduces reflectance of light incident onto the substrate 110 and increases selectivity of a specific wavelength band, thereby increasing efficiency of the solar cell 1.

In this embodiment, the refractive index of the anti-reflection layer 130 is a value that is between the refractive indices of air and the substrate 110 so that there is a sequential change in the refractive indices from air to the substrate 110. For example, the refractive indices are sequentially changed in order of air (refractive index: 1)→ the anti-reflection layer 130 (refractive index: 2.0)→ the substrate 110 (refractive index: 3.5).

The anti-reflection layer 130 also performs a passivation function to change defects such as dangling bonds mainly existing near and at the surface of the substrate 110 into stable bonds to reduce charge disappearance caused by the defects.

When the anti-reflection layer 130 is made of silicon nitride (SiNx), the anti-reflection layer (SiNx layer) 130 has an electric characteristic of a positive fixed charge. Thereby, the anti-reflection layer 130 disturbs the hole movement toward the front surface of the substrate 110, but attracts the electrons toward the front surface of the substrate 110, to improve the transmission efficiency of the charges (i.e., electrons).

In this embodiment, the anti-reflection layer 130 has a single-layered structure, but the anti-reflection layer 130 may have a multi-layered structure such as a double-layered structure. The anti-reflection layer 130 may be omitted, if desired.

The rear passivation layer unit 190 positioned on the rear surface of the substrate 110 performs the passivation function, to reduce the recombination of the charges near the rear surface of the substrate. Further, the rear passivation layer unit 190 reflects light passed through the substrate 110 back into the substrate 110, to increase an amount of light for the substrate 110.

In this embodiment, the rear passivation layer unit 190 includes a first passivation layer 191 made of silicon oxide (SiOx) and a second passivation layer 192 made of silicon nitride (SiNx).

Thereby, since the passivation function is performed by the silicon nitride layer 192 as well as the silicon oxide layer 191, the disappearance of charges by the defects near the rear surface of the substrate 110 largely decreases.

Similar to the anti-reflection layer 130, the first passivation layer 191 made of silicon oxide (SiOx) has an electric characteristic of a negative fixed charge. Thereby, the first passivation layer 191 disturbs the electron movement toward the rear surface of the substrate 110, but attracts holes toward the rear surface of the substrate 110, to improve the transmission efficiency of the charges (i.e., holes) moving toward the rear surface of the substrate 110.

As described above, the rear passivation layer unit 190 reflects the light passed through the rear surface of the substrate 110 back into the substrate 110, to increase an amount of light for the substrate 110. In this instance, for increasing the reflectance of light by the rear passivation layer unit 190, the refractive indices and thicknesses of the first and second passivation layers 191 and 192 may be appropriately adjusted or set. For example, when the first passivation layer 191 of silicon oxide (SiOx) has a range of the refractive index of 1.3 to 1.8, and the second passivation layer 192 of silicon nitride (SiNx) has a range of the refractive index of 1.9 to 2.3, the refractive indices and the thicknesses of the first and second passivation layers 191 and 192 are selected to reflect light passed through the substrate 110 into the substrate 110. In this example, the thickness of the first passivation layer 191 may be about 150nm to 220nm, and the thickness of the second passivation layer 192 may be about 15nm to 25nm.

In alternative examples, the rear passivation layer unit 190 may be a single-layered structure, or may be a triple-layered structure made of silicon oxide (SiOx), silicon nitride (SiNx), and silicon nitride oxide (SiNxOy).

When the rear passivation layer unit 190 is the single-layered structure, the silicon oxide layer (SiOx layer) may have the refractive index of about 1.3 to 1.8 and the thickness of about 150nm to 220nm. When the rear passivation layer unit 190 is the triple-layered structure, the silicon oxide layer (SiOx layer) may have the refractive index of about 1.3 to 1.8 and the thickness of about 150nm to 220nm, the silicon nitride layer (SiNx layer) may have the refractive index of about 1.9 to 2.3 and the thickness of about 15nm to 25nm, and the silicon oxy nitride (SiNxOy layer) may have the refractive index of about 1.4 to 2.0 and the thickness of about 150 nm to 240nm.

As shown in FIG. 1, the front electrode unit 140 includes a plurality of front electrodes 141 and a plurality of charge collectors 142 (hereinafter, referred to as 'a plurality of front electrode charge collectors') for the front electrodes 141.

The plurality of front electrodes 141 are connected to the emitter region 121, and spaced apart from each other by a predetermined distance and extend in a predetermined direction to be parallel to each other. The front electrodes 141 collect charges, for example, electrons, moving toward the emitter region 121.

The plurality of front electrode charge collectors 142 extend in a direction crossing the front electrodes 141 to be parallel and are connected to the plurality of front electrodes 141 as well as the emitter region 121.

In this instance, the plurality of front electrode charge collectors 142 are positioned on the same level layer as the front electrodes 141 and are electrically and physically connected to the plurality of front electrodes 141 at positions crossing each front electrode 141. Thereby, as shown in FIG. 1, each of the plurality of front electrodes 141 is a stripe shape extending in a horizontal or vertical direction and each of the plurality of front electrode charge collectors 142 is a stripe shape extending in a vertical or horizontal direction, and thereby the front electrode unit 140 is positioned in a matrix structure on the front surface of the substrate 110.

The front electrode charge collectors 142 collect the charges, for example, electrons, transferred from the front electrodes 141 as well as the charges from the emitter region 121. The front electrode charge collectors 142 are connected to an external device by ribbons, and thereby output the collected charges to the external device through the ribbons.

Since each of the front electrode charge collectors 142 collects and transfers the charges collected by the connected front electrodes 141 thereto, a width of each front electrode charge collector 142 is more than the width of each front electrode 141.

The front electrodes 140 including the front electrodes 141 and the front electrode charge collectors 142 contain at least one conductive metal material, for example, silver (Ag).

In the embodiment, the number of front electrodes 141 and the front electrode charge collectors 142 is an example, and thereby may be varied.

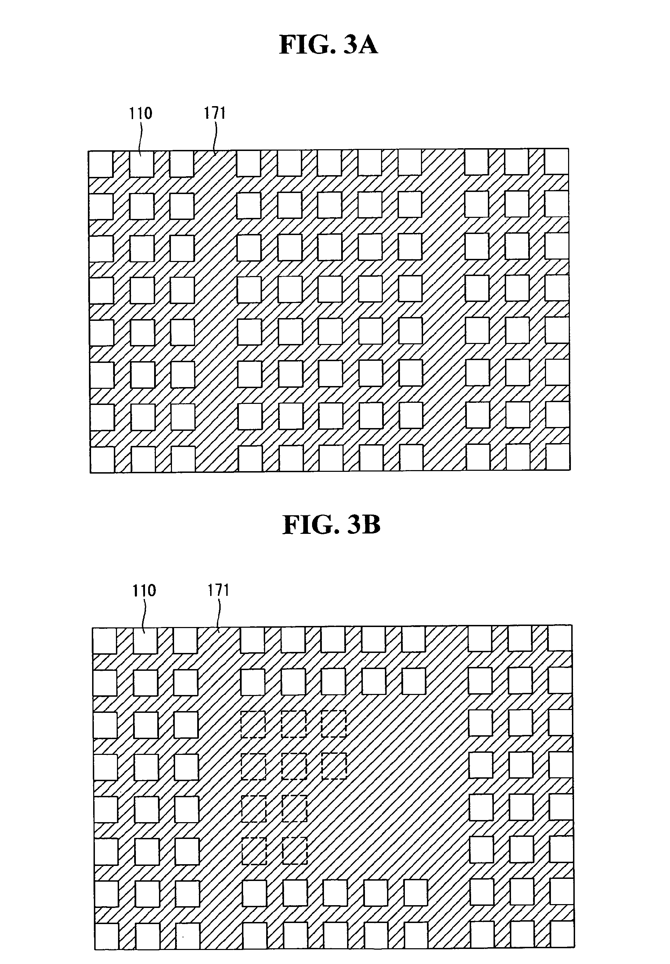

The back surface field region 171 substantially extends in a horizontal direction and a vertical direction in the rear surface of the substrate 110. That is, the back surface field region 171 includes a plurality of first portions extending in the horizontal direction and having a stripe shape and a plurality of second portions extending in the vertical direction and having a stripe shape. Thereby, as shown in FIG. 3A, the back surface field region 171 is positioned or formed in a matrix structure or shape (or a lattice structure or shape) at the rear surface of the substrate 110. In the embodiment, the number of back surface field region 171 is one. Thereby, the back surface field region 171 is not positioned in the portions between two adjacent the rear electrodes 151 and portions of the substrate 110 between the rear electrodes 151 and the rear electrode charge collectors 152. Accordingly, the back surface field region 171 have a plurality of internal portions, where portions of back surface field region 171 are not formed on the rear surface of the substrate 110

In this example, the back surface field region 171 may be positioned or formed at about 5% to 50% of the rear surface of the substrate 110. That is, the back surface field region 171 is formed on about 5% to 50% of an area of the rear surface of the substrate 110. That is, a plurality of openings (or internal portions) are present in the back surface field region 171, as shown in FIG. 3A, for example. The shape of the plurality of openings is shown in FIG. 3A as being squares or rectangles. However, embodiments of the invention include the shape of the plurality of opening being other shapes, including circular, oval, triangular, polygonal, irregular, or a combination of various shapes.

When the formation area of the back surface field region 171 is more than about 50% of the entire rear surface of the substrate 110, a formation area of the rear passivation layer unit 190 is relatively reduced and thereby the passivation effect by the rear passivation layer unit 190 may be decreased. Thus, due to the reduction of passivation effect, the recombination of charges near the rear surface of the substrate 110 may increase, to reduce the efficiency of the solar cell 1.

When the formation area of the back surface field region 171 is less than about 5% of the entire rear surface of the substrate 110, a serial resistance of the solar cell 1 may increase, and thereby amount of charges outputted to the rear electrode unit 150 may be reduced to decrease the efficiency of the solar cell 1.

In other embodiments of the invention, a formation area of the back surface field region 171 and a formation area of the rear passivation layer unit 190 need not correspond. Additionally, in embodiments of the invention, the back surface field region 171 need not be positioned or formed completely in the matrix structure or shape (or the lattice structure or shape) at the rear surface of the substrate 110.

For example, as shown in FIG. 3B, only portions of the back surface field region 171 may be formed in the matrix structure or shape (or the lattice structure or shape) to have internal portions not forming the back surface field region 171. In such an instance, one or more of the plurality of internal portions may be "filled in" or doped with impurities of the first type so as to be part of the back surface field region 171. Such "filing in" is shown by broken outline of the internal portions in FIG. 3B.

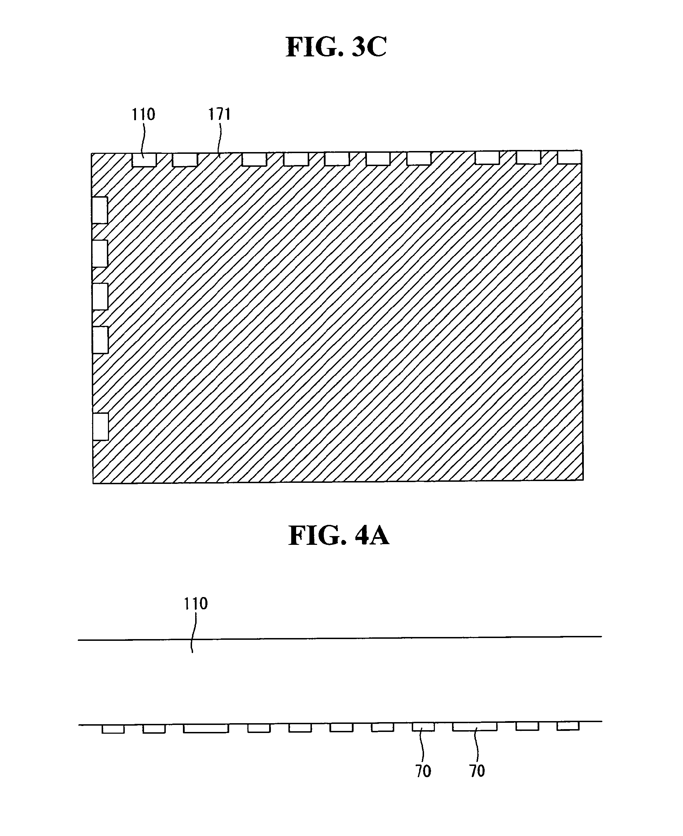

Additionally, the back surface field region 171 may be formed on the entire second surface, or substantially the entire second surface, of the substrate 110. FIG. 3C shows the back surface field region 171 being formed on substantially the entire second surface of the substrate 110. When the back surface field region 171 is formed on substantially the entire second surface of the substrate 110, the back surface field region 171 may be formed on up to 99.5% of the entire second surface of the substrate 110. In such an instance, the remaining internal portions of the back surface field region 171 may be formed anywhere on the second surface of the substrate 110, such as at outer peripheral portions of the second surface of the substrate 110. Shapes of the remaining internal portions may be squares, rectangles, or long strips. However, embodiments of the invention include the shape of the remaining internal portions being other shapes, including circular, oval, triangular, polygonal, irregular, or a combination of various shapes.

The back surface field region 171 is an area heavily doped by an impurity of the same conductive type as the substrate 110, and thereby, in this embodiment, the back surface field region 171 may be a p⁺-type area having an impurity doped concentration heavier than that of the substrate 110.

A potential barrier is formed by an impurity doped concentration difference between the substrate 110 and the back surface field region 171, thereby distributing or disturbing the movement of charges (for example, electrons) to a rear portion of the substrate 110. Accordingly, the back surface field region 171 prevents or reduces the recombination and/or the disappearance of the separated electrons and holes at the rear surface of the substrate 110.

As shown in FIGS. 1 and 2, the rear electrode unit 150 on the rear surface of the substrate 110 is substantially positioned on the back surface field region 171 to correspond to the back surface field region 171. The rear electrode unit 150 includes a plurality of rear electrodes 151 and a plurality of charge collectors 152 (referred to as 'a plurality of rear electrode charge collectors') for the rear electrodes 151. The rear electrode unit 150 and/or the back surface field region 171 may have a matrix structure or shape or a lattice structure or shape.

The plurality of rear electrodes 151 are positioned to correspond to a formation position of the back surface field region 171 and thereby extend in parallel in directions crossing each other on the rear surface of the substrate 110, along the back surface field region 171.

Thereby, as shown in FIG. 1, similar to the back surface field region 171, the plurality of rear electrodes 151 includes a plurality of portions extending in one direction (e.g., a horizontal direction) (a first direction) and having a stripe shape and a plurality of portions extending in another direction (e.g., a vertical direction) (a second direction) and having a stripe shape. Thus, the rear electrodes 151 are also positioned in a matrix structure on the rear surface of the substrate 110. In this instance, a space between adjacent two rear electrodes 151 may be defined based on a movement distance of charges, for examples, holes.

Thus, the holes moving toward the rear surface of the substrate 110 then move toward the back surface field region 171 and are collected by the rear electrodes 151 in contact with the back surface field region 171, and then transfers toward adjacent rear electrode charge collectors 152 mainly through the rear electrodes 151.

The plurality of rear electrode charge collectors 152 face the front electrode charge collectors 142 on the front surface of the substrate 110 and have stripe shapes extending along the front electrode charge collectors 142. The plurality of rear electrode charge collectors 152 collect the charges, for example, the holes moving through the plurality of rear electrodes 151 as well as the back surface field region 171. The rear electrode charge collectors 152 are connected to the external device by the ribbons, and thereby output the collected charges to the external device through the ribbons.

As described above, since the rear electrode unit 150 is positioned on the back surface field region 171 and in contact with the back surface field region 171, the rear passivation layer unit 190 is substantially positioned on portions of the rear surface of the substrate 110 on which the plurality of rear electrodes 151 and the plurality of rear electrode charge collectors 152 are not positioned.

As shown in FIGS. 1 and 2, to improve the transmission efficiency of the charges by reduction of a wire resistance of each rear electrode charge collector 152 and a contact resistance with the external device through the conductive tape, etc., a width of each rear electrode charge collector 152 is larger than that of each rear electrode 151, and thereby widths of a portions of each back surface field region 171, to which rear electrode charge collectors 152 are contacted, are also larger than those of portions of the back surface field region 171, to which the rear electrodes 151 are contacted.

In the embodiment, the number of rear electrode charge collectors 152 is equal to the number of front electrode charge collectors 142. A width of each rear electrode charge collector 152 is also substantially equal to that of each front electrode charge collectors 142. However, in alternative examples, the width of each rear electrode charge collector 152 may be more than that of each front electrode charge collectors 142. In this instance, the transmission efficiency of the charges through the rear electrode charge collectors 152 is improved.

The rear electrode unit 150 including the plurality of rear electrodes 151 and the plurality of rear electrode charge collectors 152 may be made of the same material as the front electrode unit 140. Thereby, the rear electrode unit 150 may contain at least one conductive metal material such as silver (Ag) or aluminum (Al). When the rear electrode unit 150 contains silver (Ag), the conductivity of the rear electrode unit 150 is improved, and thereby the charge transmission efficiency of the rear electrode unit 150 increases. On the other hand, when the rear electrode unit 150 contains aluminum (Al), the manufacturing cost of the solar cell 1 decreases. Unlike this embodiment, the solar cell 1 need not include the plurality of rear electrode charge collectors 152, but at least one rear electrode 151 is positioned on the rear surface of the substrate 110 to face one front electrode charge collector 142. In this instance, the ribbons are directly connected to the plurality of rear electrodes 151 to face the plurality of front electrode charge collectors 142, thereby collecting the charges toward the ribbons. In this instance, since the plurality of rear electrode charge collectors are omitted, the first and second portions of the back surface field region 171 have the substantially same width and extend in directions (e.g., in horizontal and vertical directions) crossing each other. In addition, the back surface field region 171 is in contact with the plurality of rear electrodes 151. The widths of the first and second portions of the back surface field region 171 are defined based on the width of the rear electrodes 151.

When the plurality of rear electrode charge collectors 152 having the widths greater than the plurality of the rear electrodes 151 are omitted, the manufacturing cost of the solar cell is reduced.

Alternatively, the plurality of rear electrodes 151 and the plurality of rear electrode charge collectors 152 may be made of different materials from each other. For example, the plurality of rear electrodes 151 may contain aluminum (Al), but the plurality of rear electrode charge collectors 152 may contain silver (Ag). In this instance, since the plurality of rear electrodes 151 are made of aluminum (Al) that is cheaper than silver (Ag), the manufacturing cost of the rear electrode unit 150 is reduced.

The rear reflection layer 161 positioned on the second passivation layer 192 of the rear passivation layer unit 190, and is substantially positioned on the second passivation layer 192 on which the plurality of the rear electrodes 151 and the plurality of rear electrode charge collectors 152 are not positioned.

The rear reflection layer 161 contains at least one conductive material such as aluminum (A1) and is in contact with the adjacent rear electrodes 151 or rear electrode charge collectors 152.

The rear reflection layer 161 reflects light, for example, light in a long wavelength band, passed through the rear surface of the substrate 110 toward the substrate 110, to reduce a loss amount of light through the substrate 110. In addition, since the rear reflection layer 161 is made of the conductive material, the charges transferred to adjacent rear electrodes 151 are moved to the rear electrode charge collectors 152 through the rear reflection layer 161. Thereby, the charges moves through the rear reflection layer 161 as well as the substrate 110 and/or the rear electrodes 151, and thereby the transmission efficiency of the charges to the rear electrode charge collectors 152 is improved.

However, alternatively, the rear reflection layer 161 may be non-conductive material reflecting light to the substrate 110. In this instance, the rear reflection layer 161 may be opaque materials reflecting light passed through the substrate 110 to the substrate 110.

In addition, unlike this example, the rear reflection layer 161 may be omitted, if it is necessary or desired. In this instance, since light is incident onto all the front and rear surfaces of the substrate 110, a light receiving area of the solar cell 1 increases, and thereby an amount of light incident into the substrate 110 increases to improve the efficiency of the solar cell 1.

A width of each rear electrode 151 may be equal to or greater than a width of each front electrode 141. For example, when light is incident onto only the front surface of the substrate 110, the light receiving area is not reduced by the formation area of the rear electrodes 151. Thus, for increasing the transmission efficiency of the charges and reducing the wire resistance, the widths of the rear electrodes 151 may be enlarged.

The solar cell 1 according to the embodiment includes the passivation layer unit 190 on the rear surface of the substrate 110, to reduce the recombination/disappearance of the charges due to defects (e.g., the unstable bonds) existing near the rear surface of the substrate 110. An operation of the solar cell 1 of the structure will be described in detail.

When light irradiated to the solar cell 1 is incident on the substrate 110 of the semiconductor through the anti-reflection layer 130 and the emitter region 121, a plurality of electron-hole pairs are generated in the substrate 110 by light energy based on the incident light. In this instance, since a reflection loss of light incident onto the substrate 110 is reduced by the anti-reflection layer 130, an amount of the incident light on the substrate 110 increases.

The electron-hole pairs are separated by the p-n junction of the substrate 110 and the emitter region 121, and the separated electrons move toward the emitter region 121 of the n-type and the separated holes move toward the substrate 110 of the p-type. The electrons moved toward the emitter region 121 are collected by the front electrode unit 140, while the holes moved toward the substrate 110 are collected by the rear electrode unit 150 through the back surface field region 171.

Then, when the plurality of front electrode charge collectors 142 of the front electrode unit 140 and the plurality of rear electrode charge collectors 152 of the rear electrode unit 150 are connected to each other by wires such as the conductive tapes, etc., current flows therein to thereby enable use of the current for electric power in the external device.

In this instance, when the rear reflection layer unit 190 is positioned on the rear surface of the substrate 110, the recombination and/or disappearance of the charges due to the unstable bonds of the surface of the substrate 110 is largely reduced to improve the efficiency of the solar cell 1. In addition, since the loss of light passed through the substrate 110 decreases and the transmission efficiency of the solar cell 1 is improved by the rear reflection layer 161, to further improve the efficiency of the solar cell 1.

Next, referring to FIGS. 4A to 4G, discussed is a method for manufacturing the solar cell 1 according to an example embodiment of the invention.

As shown in FIG. 4A, a doping material is applied on portions of a rear surface of a substrate 110 made of p-type polycrystalline silicon and dried at a low temperature, to form a back surface field region pattern 70. In this instance, the doping material contains p-type impurities and particles (Group IV particles) of a Group IV element and is one of an ink-type. The back surface field region pattern 70 is extended in vertical and horizontal direction on the rear surface of the substrate 110 and thereby is applied as a matrix structure.

In the embodiment, the Group IV particles are particles of a nanosize (in a width and/or a height), that is, Group IV nanopaticles. In this instance, the nanoparticle is a microscopic particle with at least one dimension less than 100nm. The term "Group IV nanoparticle" generally refers to hydrogen terminated Group IV nanoparticle having an average diameter between about 1 nm to 100nm. Thereby, the doping material of the back surface field region pattern 70 may be Group IV nanoparticles containing the n-type impurities.

In the embodiment, the Group IV particles contain silicon (Si) which is the same material as the substrate 110, but the Group IV particles may contain semiconductors other than silicon (Si) and combination thereof.

In comparison to a bulk material (>100nm) which tends to have constant physical properties regardless of its size (e.g., melting temperature, boiling temperature, density, conductivity, etc.), nanoparticles may have physical properties that are size dependent, and hence useful for applications such as junction. For example, semiconductor nanoparticles may be more easily and cheaply patterned into forming semiconductor junctions when compared to alternate methods, such as silk-screening or deposition.

Also, assembled nanoparticles may be suspended in a colloidal dispersion or colloid, such as an ink, in order to transport and store the nanoparticles. Generally, colloidal dispersions of Group IV nanoparticles are possible because the interaction of the particles surface with the solvent is strong enough to overcome differences in density, which usually result in a material either sinking or floating in a liquid. That is, smaller nanoparticles disperse more easily than larger nanoparticles. In general, the Group IV nanoparticles are transferred into the colloidal dispersion under a vacuum, or an inert substantially oxygen-free environment.

The back surface field reg ion pattern 70 containing the n-type impurities and the Group IV nanoparticles may be formed by a direct printing method capable of directly printing or applying a desired material on desired portions such as an ink-jet printing method, an aerosol-coating method, or an electro-spray coating method, etc.

If desire, before forming the back surface field region pattern 70, various processes may be performed, such as a saw damage etching process for removing damage portions formed on surfaces of the substrate 110 in a slicing process for preparing the substrate 110 for solar cells 1, a texturing process to form a textured surface which is an uneven surface in the surface of the substrate 110, or a cleaning process for the substrate 110, etc., to improve a surface state of the substrate 110.

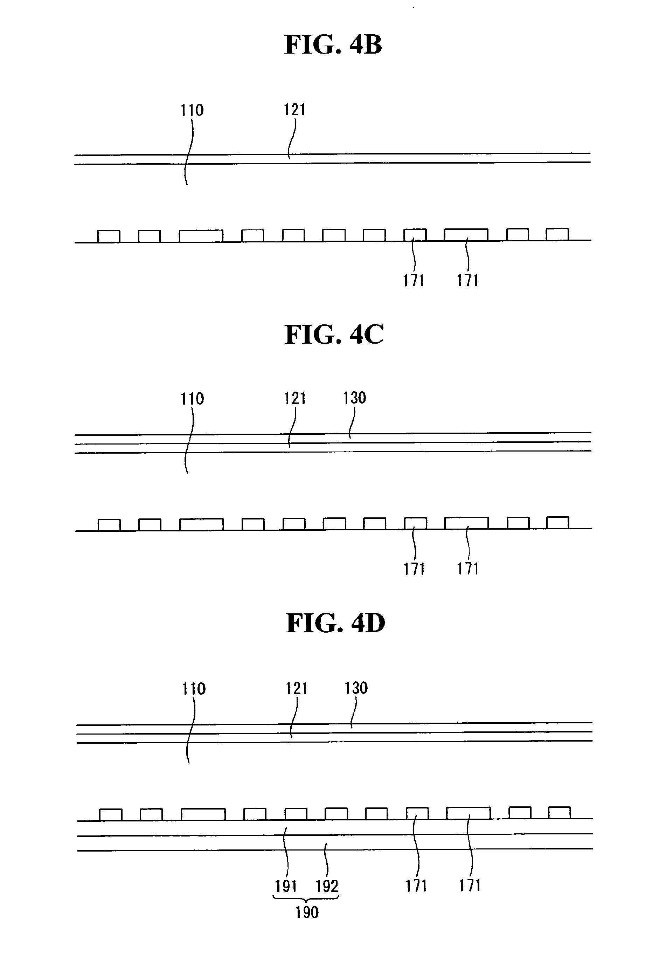

Then, as shown in FIG. 4B, a doping material containing a group V element impurity such as P, As, or Sb is applied on the front surface of the substrate 110 using an in-line diffusion system and then a thermal process is performed on the substrate to diffuse the group V element impurity into the front surface of the substrate 110 and to thereby form an n-type emitter region 121 having a conductive type different from the substrate 110.

That is, when the substrate 110 with the back surface field region pattern 70 is moved along a process line and then posited under an injecting device injecting the doping material, an injecting nozzle of the injecting device injects the doping material to an exposed surface (i.e., the front surface) of the substrate 110 to apply the doping material on the front surface of the substrate 110. Then, the substrate 110 having the back surface field region pattern 70 and the doping material (the impurity material) is heated to form the back surface field region 171 and the emitter region 121.

In the thermal process, since the back surface field region pattern 70 containing the p-type impurity is already applied on the rear surface of the substrate 110, the p-type impurity of the back surface field region pattern 70 is driven into the substrate 110 to form the back surface field region 171 having an impurity doped concentration higher than that of the substrate 110, and then the back surface field region pattern 70 existing on the rear surface of the substrate 110 is removed. Thereby, when the thermal process for the formation of the emitter region 121 is performed, the back surface field region 171 is formed in (at) portions of the substrate 110 on which the back surface field region pattern 70 is applied, along with the emitter region 121.

In this instance, since the back surface field region pattern 70 contains silicon, as is the case with the substrate 110, a chemical reaction between the back surface field region pattern 70 and the substrate 110 is easily performed, and thereby the diffusion operation of the impurity of the back surface field region pattern 70 is easily performed. As described above, since the nanoparticles of the ink have a nano size, reactivity of the nanoparticles is good. Thus, the diffusion operation of the phosphor (P) into the substrate 110 is also easily performed.

Next, if necessary or desired, phosphorous silicate glass (PSG) containing phosphor (P) produced on the front surface of the substrate 110 when the p-type impurity is diffused into the substrate 110 is removed through an etching process using HF, etc.

Unlike the embodiment, when the substrate 110 is of the n-type, a doping material containing a group III element impurity is applied on the front surface of the substrate 110 and then a thermal process is performed on the substrate 110 to form a p-type emitter region in the front surface of the substrate 110.

Thereby, the emitter region 121 and the back surface field region 171 are simultaneously formed using one thermal process, to reduce a manufacture time of the emitter region 121 and the back surface field region 171.

Next, as shown in FIG. 4C, an anti-reflection layer 130 made of silicon nitride (SiNx) is formed on the emitter region 121 in the front surface of the substrate 110 using a plasma enhanced chemical vapor deposition (PECVD), etc. At time, the anti-reflection layer 130 has a refractive index, for example, about 1.9 to 2.3, that is intermediate of a refractive index (1) of air and a refractive index (about 3.8) of the silicon substrate 110. Thereby, the refractive index is sequentially varied from that of air to that of the substrate 110, to improve an anti-reflection effect of the anti-reflection layer 130.

Next, as shown in FIG. 4D, using various film forming methods such as a PECVD, etc., a first passivation layer 191 of silicon oxide (SiOx) on the rear surface of the substrate 110 and a second passivation layer 192 of silicon nitride (SiNx) on the first passivation layer 191 are formed to form a rear passivation layer unit 190.

In the embodiment, after the formation of the anti-reflection layer 130 on the front surface of the substrate 110, the rear passivation layer unit 190 on the rear surface of the substrate 110 is formed. However, reversely, the rear passivation layer unit 190 may be formed first and then afterwards, the anti-reflection layer 130 may be formed.

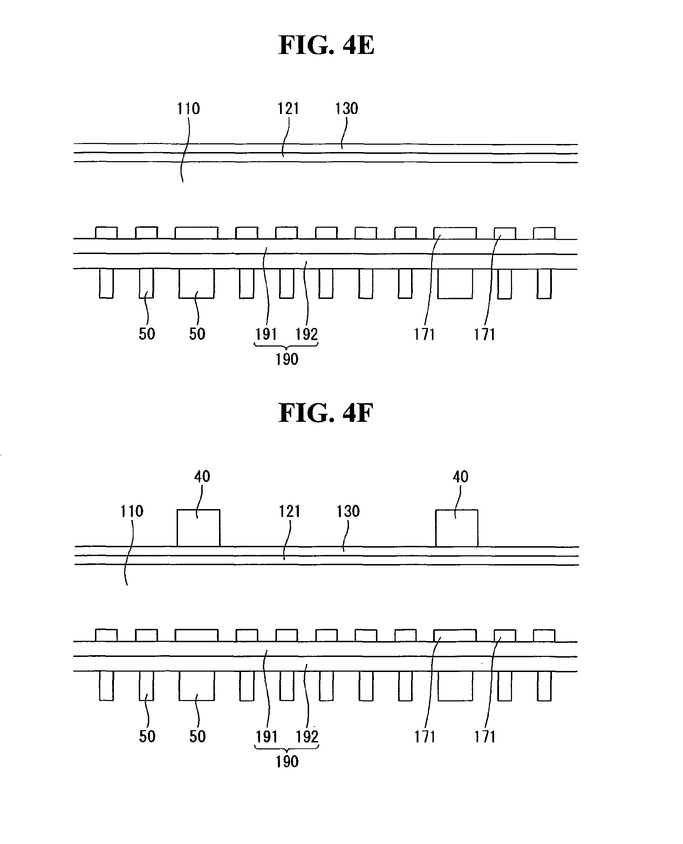

Sequentially, as shown in FIG. 4E, a paste containing Ag is applied on portions of the second passivation layer 192 of the rear passivation layer unit 190 using a screen printing method and then is dried at about 120 °C to 200 °C to form a rear electrode unit pattern 50.

In this instance, the rear electrode unit pattern 50 is formed along the back surface field region 171, and includes rear electrode pattern portions and rear electrode charge collector pattern portions extending in directions crossing each other, respectively. A width of each rear electrode charge collector portion is wider than that of each rear electrode pattern portion, but it is not limited thereto.

When the plurality of rear electrodes 151 and the plurality of rear electrode charge collectors 152 are to be made of different materials from each other, the rear electrode pattern portions and the rear electrode charge collector portions are separately formed, For example, a paste containing aluminum (Al) is applied on the rear passivation layer unit 190 and dried to form the rear electrode pattern portions, while a paste containing silver (Ag) is applied on the rear passivation layer unit 190 and dried to form the rear electrode charge collector pattern portions,

Next, as shown in FIG. 4F, a paste containing Ag is applied on portions of the anti-reflection layer 130 using a screen printing method and then is dried at about 120 °C to 200 °C to form a front electrode unit pattern 40. The front electrode unit pattern 40 also includes front electrode pattern portions and front electrode charge collector pattern portions extending in directions crossing each other, respectively.

In this instance, the extending direction of each front electrode charge collector pattern portion is equal to that of each rear electrode charge collector pattern portion, and the front electrode charge collector pattern portions are positioned opposite to rear electrode charge collector pattern portions with respect to the substrate 110 so as to face the rear electrode charge collector pattern portions.

Further, widths of the front electrode charge collector pattern portions and the rear electrode charge collector pattern portions are wider than those of the front electrode pattern portions and the rear electrode pattern portions, respectively, but it is not limited thereto.

In addition, the widths of the rear electrode pattern portions and the front electrode pattern portions are substantially equal to each other, but the widths of the rear electrode pattern portions may also be larger than those of the front electrode pattern portions. A space between two adjacent rear electrode charge collector pattern portions is less that of between the two adjacent front electrode charge collector pattern portions, but it is also not limited thereto.

In an alternative example, the rear electrode pattern portions containing silver (Ag) may be positioned at portions of the passivation layer unit 190 which face the front electrode charge collector pattern portions. In this instance, a completed rear electrode unit includes only a plurality of rear electrodes containing silver (Ag).

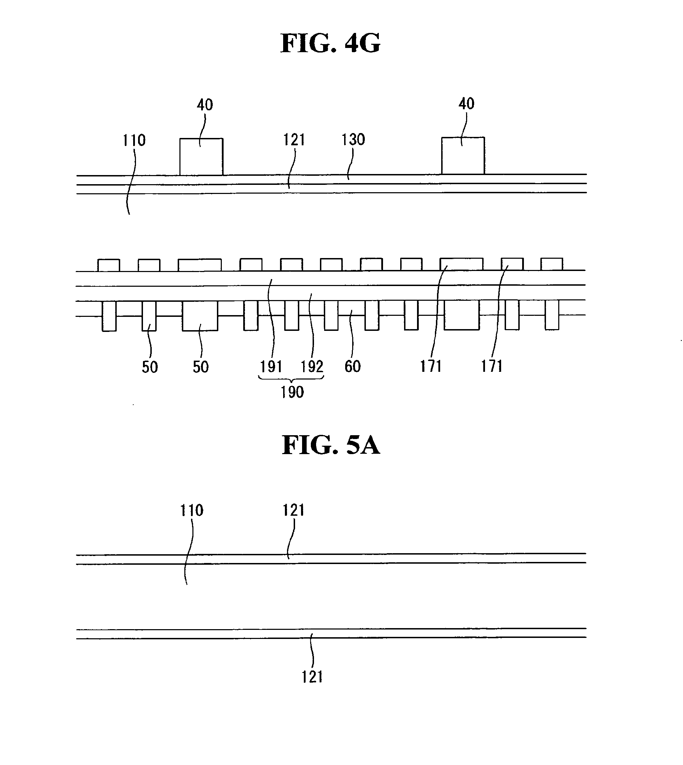

Next, as shown in FIG. 4G, a paste containing Al is applied on portions of the second passivation layer 192, on which the rear electrode unit pattern 50 is not positioned using a screen printing method and then is dried at about 120 °C to 200 °C to form a rear reflection layer pattern 60. A thickness (a height) of the rear reflection layer pattern 60 is less than that of the rear electrode unit pattern 50, but alternatively, may be equal to or greater than that of the rear electrode unit pattern 50. Alternatively, when the solar cell 1 does not have the rear reflection layer 161, the process for forming the rear reflection layer pattern 60 is omitted.

In this embodiment, the patterns 40, 50, and 60 contain glass frit. However, in other embodiments the rear electrode unit pattern 50 and the front electrode unit pattern 40 may contain Pb, while the rear reflection layer pattern 60 does not contain Pb.

A formation order of the patterns 40, 50, and 60 may be changed.

Then, a firing process is performed on the substrate 110, on which the patterns 40, 50 and 60 are formed at a temperature of about 750°C to 800°C, to form a front electrode unit 140 including a plurality of front electrodes 141 and a plurality of front electrode charge collectors 142 and connected to the emitter region 121, a rear electrode unit 150 including the plurality of rear electrodes 151 and a plurality of rear electrode charge collectors 152 and connected to the back surface field region 171, and the rear reflection layer 161 positioned on the second passivation layer 192. As a result, the solar cell 1 shown in FIGS. 1 and 2 is completed.

More specifically, when the thermal process is performed, by functions of lead (Pb) etc., contained in the front electrode unit pattern 40, the front electrode unit pattern 40 penetrates through the anti-reflection layer 130 underlying the front electrode unit pattern 40. Thereby, the plurality of front electrodes 141 and the plurality of front electrode charge collectors 142 connected to the emitter region 121 are formed to complete the front electrode unit 140. In addition, the rear electrode unit pattern 50 sequentially penetrates through the second and first passivation layers 192 and 191 and thereby is connected to the back surface field region 171. Thereby, the plurality of rear electrodes 151 and the plurality of rear electrode charge collectors 152 connected to the back surface field region 171 are formed, to complete the rear electrode unit 150.

In this instance, the front electrode pattern portions of the front electrode unit pattern 40 and the rear electrode pattern portions of the rear electrode unit pattern 50 become the plurality of front electrodes 141 and the plurality of rear electrodes 151, respectively, and the front electrode charge collector pattern portions of the front electrode unit pattern 40 and the rear electrode charge collector pattern portions of the rear electrode unit pattern 50 become the plurality of front electrode charge collectors 142 and the plurality of rear electrode charge collectors 152, respectively.

Moreover, in performing the thermal process, metal components contained in the patterns 40, 50, and 60 are chemically coupled to the contacted portions of the emitter region 121, the substrate 110 and the second passivation layer 192, respectively, such that a contact resistance is reduced and thereby a transmission efficiency of the charges is improved to improve a current flow.

When a thickness of the rear passivation layer unit 190 is increased by the multi-layered structure, laser beams, etc., may be irradiated on portions of the rear surface of the substrate 110, to help the rear electrode unit 150 to contact the back surface field region 171.

For example, after the thermal process for the formation of the rear electrode unit 140 and the rear electrode unit 150, the laser beams may be further irradiated on the portions of the rear surface of the substrate 110, on which the rear electrode unit pattern 50 is positioned, to make the rear electrode unit pattern 50 and the back surface field region 171 stably contact therebetween. Thus, a contact error between the rear electrode unit 150 and the back surface field region 171 is reduced.

Before or after forming the rear electrode unit pattern 50, and after the front electrode unit 140 are formed through the thermal process, the laser beams may be irradiated on the rear electrode unit pattern 50 to perform the electric and physical connection of the rear electrode unit 150 and the back surface field region 171. In this instance, since only the front electrode unit 140 is formed in the thermal process, a temperature and the time of the thermal process for the front electrode unit 140 are reduced, to decrease the characteristic variation of the substrate 110 and/or other portions which are already formed in or on the substrate 110. It is not necessary for the rear electrode unit pattern 50 to penetrate the thick rear passivation layer unit 190. Thus, the rear electrode unit pattern 50 need not contain, or may only contain a reduce content of an environment pollution material such as Pb.

The completion of the solar cell 1, an edge isolation process may be performed to remove portions of the side portions or predetermined thicknesses of the substrate 110 using laser beams or an etching process. Thereby, damage portions occurred or generated during the thermal process, or pollution materials that are attached to the side portions are removed. A time of the edge isolation process may be changed and the edge isolation process may be omitted if it is necessary or desired.

Since it is not necessary to form a plurality of holes in the rear passivation layer unit 190 and then to inject an impurity into the substrate 110 through the holes for forming the back surface field region 171, manufacturing processes and manufacturing time of the solar cell 1 decrease.

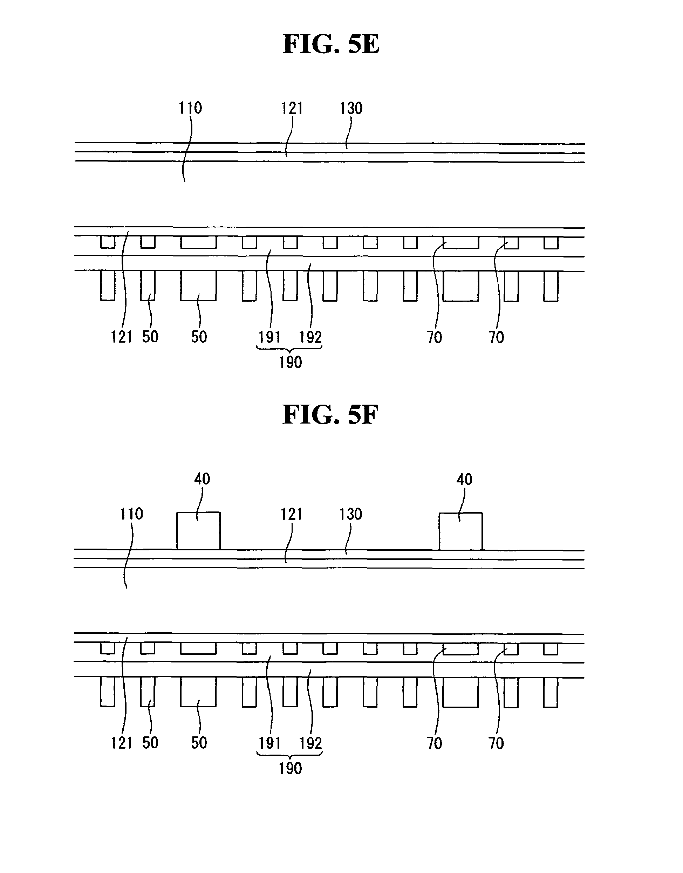

Next, another method for manufacturing the solar cell 1 according to an example embodiment of the invention will be described referring to FIGS. 5A to 5H, as well as 4a to 4F. As compared with FIGS. 4A to 4F, the elements performing the same operations are indicated with the same reference numerals, and the detailed description thereof is omitted.

As shown in FIG. 5A, a high temperature thermal process involving a material (for example, POCl₃ or H₃PO₄) containing a group V element impurity is performed on the substrate 110 to diffuse the group V element impurity into the substrate 110, thus forming an emitter region 121 which contains the impurity. Hence, the emitter region 121 is formed on the entire surface of the substrate 110 including a front surface, a rear surface, and side surfaces. Unlike the embodiment when the substrate 110 is of the n-type, a high temperature thermal process involving material (for example, B₂H₆) containing a group III element impurity is performed on the substrate 110 to form a p-type emitter region in the entire surface of the substrate 110. Next, phosphorous silicate glass (PSG) containing phosphor (P) or boron silicate glass (BSG) containing boron (B) produced when the n-type impurity or the p-type impurity is diffused into the substrate 110 is removed through an etching process using HF, etc.

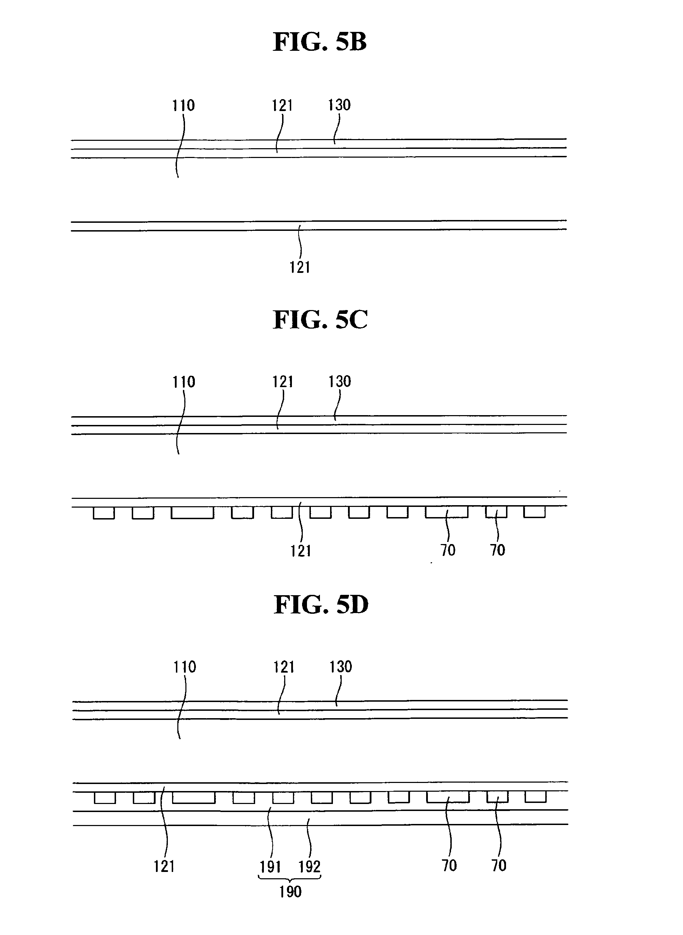

Next, as shown in FIG. 5C, which is after the formation of an anti-reflection layer 130 on the front surface of a substrate 110 shown in FIG. 5B (similar to the FIG. 4A), a back surface field region pattern 70 is formed on a rear surface of the substrate 110 using a direct printing method capable of directly printing or applying a desired material on desired portions, such as an ink-jet printing method, an aerosol-coating method, or an electro-spray coating method, etc. As described above, the back surface field region pattern 70 includes a p-type impurity similar to the substrate 110 and a Group IV element.

Sequentially, as shown in FIG. 5D, a rear passivation layer unit 190 is formed on the entire rear surface of the substrate 110 on which the back surface field region pattern 70 is formed. In this embodiment, the rear passivation layer unit 190 is a double-layered structure including first and second passivation layers 191 and 192.

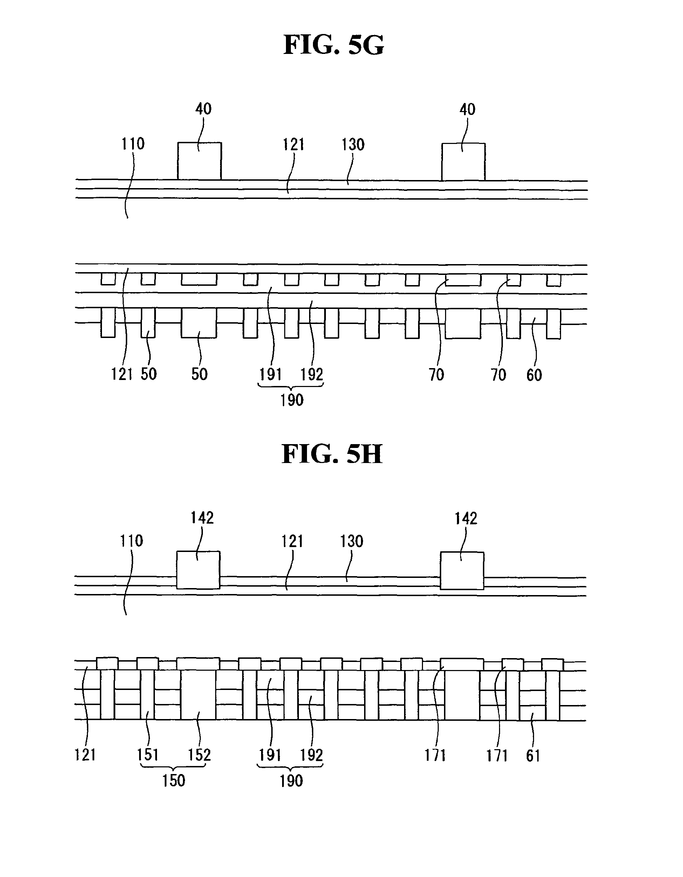

Then, as shown in FIGS. 5E to 5F, a rear electrode unit pattern 50 and a front electrode unit pattern 40 are formed on the rear surface and a front surface of the substrate 110, respectively. Next, as shown in FIG. 5G, a rear reflection layer pattern 60 is formed on portions of the rear surface of the substrate, on which the rear electrode unit pattern 50 is not formed, similar to FIG. 4G).

Next, as shown in FIG. 5H, when a firing process is performed on the substrate with the patterns 50, 40 and 60, the front electrode unit pattern 40 penetrates through the anti-reflection layer 130 to form a front electrode unit 140 connected to the emitter region 121 and the rear electrode unit pattern 50 penetrates through the rear passivation layer unit 190 to form a rear electrode unit 150 connected to the rear surface of the substrate 110. In addition, the impurity contained into the back surface field region pattern 70 is driven into the rear surface of the substrate 110 by heat applied by the thermal process, to form a back surface field region 171 on the rear surface of the substrate 110. Next, an edge isolation process may be performed to remove the emitter region 121 formed on the side surfaces of the substrate 110.

As described above, according to the embodiment, the front electrode unit 140, the back surface field region 171 and the rear electrode unit 150 are formed by one thermal process. In this instance, the rear electrode unit 150 is connected to the substrate 110 through the back surface field region 171. In the embodiment, since the emitter region 121 is formed at the rear surface of the substrate 110, the emitter region 121 is positioned on portions of the rear surface of the substrate 110 on which the back surface field region 171 is not positioned.

Further, since the rear passivation layer unit 190 is formed on the back surface field region pattern 70, the rear electrode unit 150 may contain components of the back surface field region pattern 70.

However, after the formation of the emitter region 121 and before the formation of the back surface field region pattern 70, the emitter region 121 formed on the rear surface of the substrate 110 may be removed, and thereby the emitter region 121 need not exist on the rear surface of the substrate 110.

Thereby, in the thermal process for the front electrode unit 140 and the rear electrode unit 150, the back surface field region 171 is also formed, and thereby the manufacturing processes of the solar cell 1 are simplified.

As described previously, to stably form the back surface field region 171 and to reduce a contact error between the back surface field region 171 and the rear electrode unit 150, a process using laser beams may be performed. For example, after the thermal process for the front electrode unit 140 and the rear electrode unit 150 are formed, the laser beams are irradiated on the rear electrode unit pattern 50. Alternatively, irrespective of the formation of the front electrode unit 140, the laser beams may be irradiated on the rear electrode unit pattern 50, to form the rear electrode unit 150 along with the back surface field region 171. In the latter instance, manufacturing processes of the solar cell are simplified, and the characteristic variation and the environment pollution are also reduced.

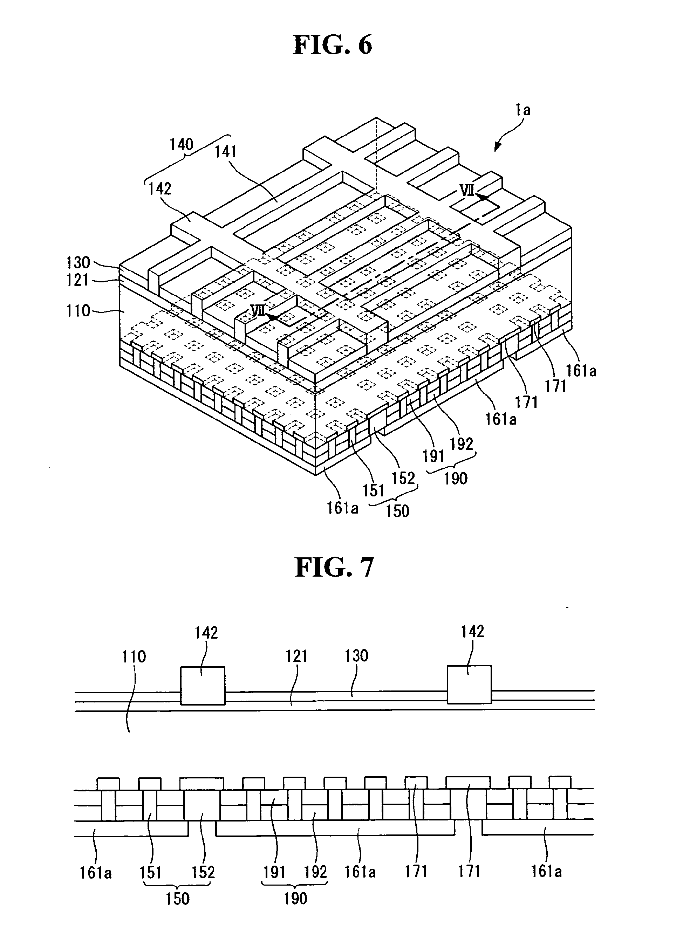

Next, referring to FIGS. 6 to 8, a solar cell according to another embodiment of the invention will described.

As compared with FIG. 1 to FIGS. 3A-3C, the elements performing the same operations are indicated with the same reference numerals, and the detailed description thereof is omitted.

A solar cell 1a according to the embodiment includes a similar structure to that of the solar cell 1 shown in FIGS. 1 and 2.

That is, the solar cell 1a includes a substrate 110, an emitter region 121 in the substrate 110, an anti-reflection layer 130 positioned on the emitter region 121, a rear passivation layer unit 190 positioned on a rear surface of the substrate 110 and including first and second passivation layers 191 and 192, a front electrode unit 140 including a plurality of front electrodes 141 and a plurality of front electrode charge collectors 142 and connected to the emitter region 121, a back surface field region 171 locally positioned at the rear surface of the substrate 110, a rear electrode unit 150 including a plurality of rear electrodes 151 and a plurality of rear electrode charge collectors 152 and connected to the substrate 110 through the back surface field region 171, and a rear reflection layer 161a positioned on the rear surface of the substrate 110.

However, unlike the embodiments of FIG. 1 to FIGS. 3A-3C, and except for portions of the plurality of rear electrode charge collectors 152 and portions of an edge region of the rear surface of the substrate 110, the rear reflection layer 161a is positioned on the plurality of rear electrodes 151 and the second passivation layer 192 as shown in FIGS. 6 to 8. In this instance, the rear reflection layer 161a overlaps portions of the rear electrode charge collectors 152 adjacent thereto.

Since the rear reflection layer 161a is positioned on the rear electrode unit 150, the rear electrode unit 150 is positioned under the rear reflection layer 161a and is in contact with portions of the back surface field region 171 by penetrating through the second and first passivation layers 192 and 191.

The rear reflection layer 161a is positioned on the rear electrode unit 150 as well as the rear passivation layer unit 190, and thereby a light refection effect by the rear reflection layer 161a is further improved to increase a light amount for the substrate 110. Moreover, charges move toward the plurality of rear electrode charge collectors 152 through the rear reflection layer 161a, so that a charge amount collected by the plurality of rear electrode charge collectors 152 increases.

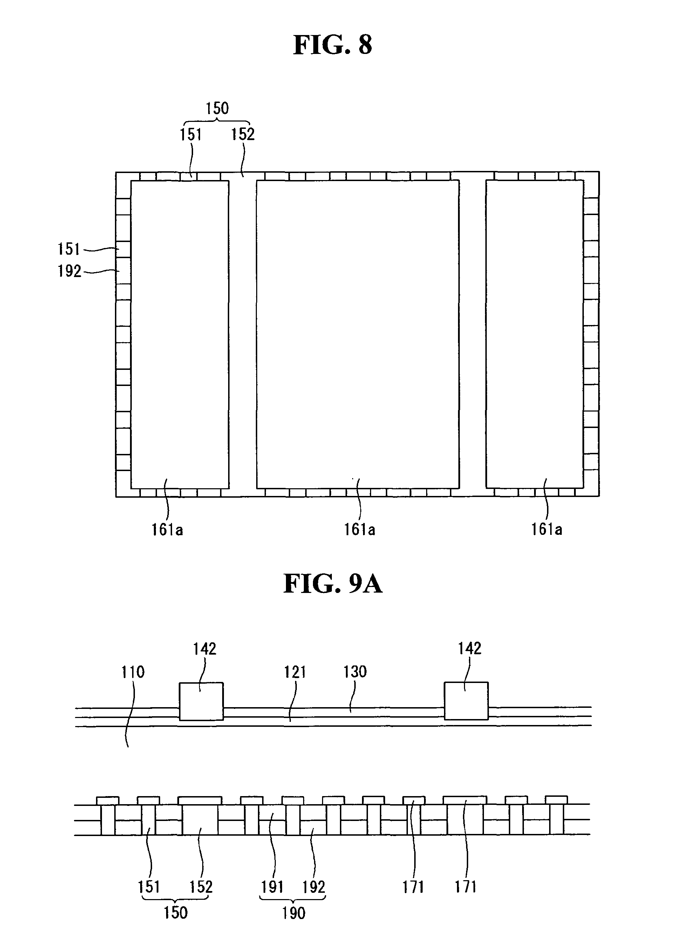

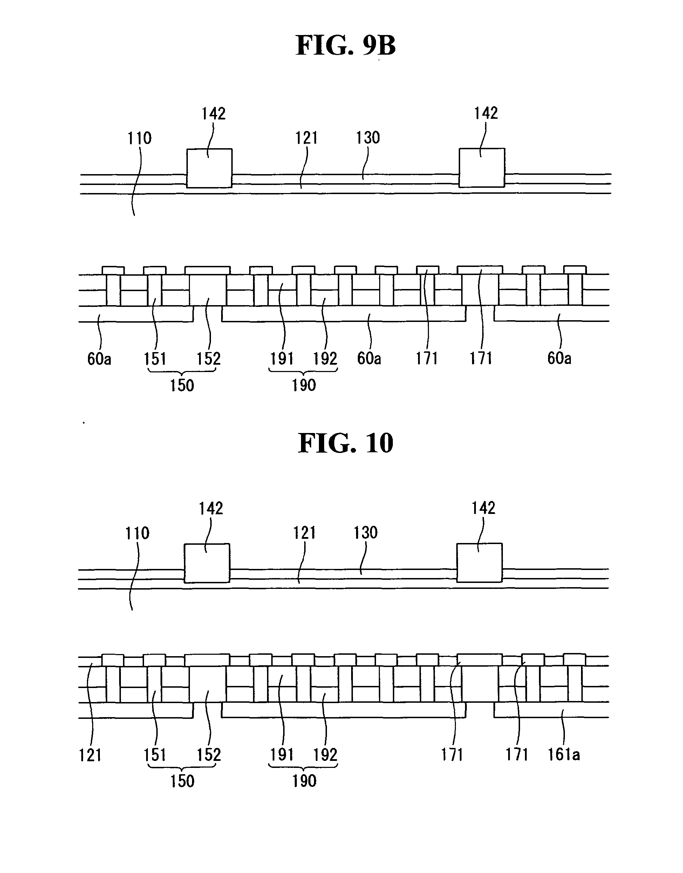

A method for manufacturing the solar cell 1a will be described with respect to FIGS. 9A and 9B, as well as FIGS. 4A to 4F.

As already described with reference to FIGS. 4A to 4D, an emitter region 121 and a back surface field region 171 are formed at a front surface and a rear surface of the substrate 110, respectively, an anti-reflection layer 130 is formed on the emitter region 121, and first and second passivation layers 191 and 192 are formed on the rear surface of the substrate 110.

Next, as described with reference to FIGS. 4E and 4F, a rear electrode unit pattern 50 and a front electrode unit pattern 40 are formed on the rear and front surfaces of the substrate 110, respectively.

Then, when the substrate 110 with the patterns 40 and 50 is heated at a high temperature (e.g., about 750°C to 800°C), the front electrode unit pattern 40 penetrates the anti-reflection layer 130 to form a front electrode unit 140 that is connected to the emitter region 121 and includes a plurality of front electrodes 141 and a plurality of front electrode charge collectors 142, and the rear electrode unit pattern 50 penetrates the second and first passivation layers 192 and 191 to form a rear electrode unit 150 connected to the back surface field region 171 and includes a plurality of rear electrodes 151 and a plurality of rear electrode charge collectors 152 as shown in FIG. 9A.

Thereby, since the emitter region 121 and the back surface field region 171 are formed by one thermal process, manufacturing time of the solar cell 1a is reduced.

Then, as shown in FIG, 9B, a paste is applied on the plurality of rear electrodes 151, the second passivation layer 192, and portions of the plurality of rear electrode charge collectors 152 using a screen printing method and then dried at a low temperature (e.g., about 120°C to 200°C), to form a reflection layer pattern 60a. In this instance, the paste may contain aluminum (Al). Thereby, the solar cell 1a shown in FIGS. 6 and 7 is completed.

When manufacturing the solar cell 1a with reference to FIGS. 5A to 5F, and 9A and 9B, the emitter region 121 exists at portions of the rear surface of the substrate 110 as shown in FIG. 10. However, as already described, before the formation of the back surface field region pattern 70, the emitter region 121 at the portions of the rear surface of the substrate 110 may be removed, and thereby the emitter region 121 need not exist at the rear surface of the substrate 110.

As described above, in alternative examples, the plurality of rear electrodes 151 contain aluminum (Al) instead of silver (Ag). Since the rear electrodes 151 are made of aluminum (Al) that is cheaper than silver (Ag), the manufacturing cost of the solar cell is reduced.

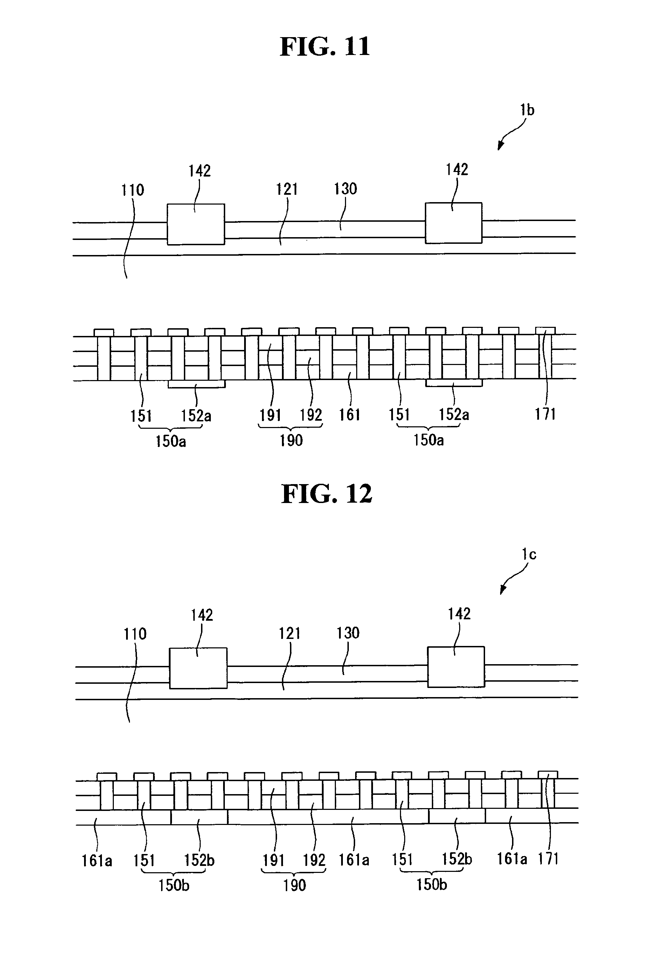

In this instance, as shown in FIGS. 11 and 12, the rear electrode units 150a and 150b include a plurality of rear electrodes 151 containing aluminum (Al) and a plurality of rear electrode charge collectors 152a and 152b containing silver (Ag), respectively. In this instance, the plurality of rear electrode charge collectors 152a and 152b face the front electrode charge collectors 142 positioned on the front surface of the substrate 110. In other words, the plurality of rear electrode charge collectors 152a and 152b are aligned with the front electrode charge collectors 142.

In FIGS. 11 and 12, at least one of the rear electrodes 151 that contacts the respective rear electrode charge collectors 152a and 152 has the same width as widths of the other rear electrodes 151 that do not contact the rear electrode charge collectors 152a and 152b. However, the rear electrode 151 that contacts the respective rear electrode charge collectors 152a and 152 may have a width that is larger than the widths of the other rear electrodes 151 that do not contact the rear electrode charge collectors 152a and 152b in similar fashion as shown in FIGS. 2 and 7. In this instance, the respective rear electrode charge collectors 152a and 152b may be in contact with one rear electrode 151.

Since only the rear electrode charge collectors 152 are connected to ribbons for connecting to an external device contain silver (Ag), the manufacturing cost of the rear electrode units 150a and 150b is largely reduced without a reduction in the transmission efficiency of the charges.

As compared with FIG. 2, as shown in FIG. 11, each rear electrode charge collector 152a is positioned on the rear reflection layer 161 and at least one rear electrode 151. As compared with FIG. 7, as shown in FIG. 12, each rear electrode charge collector 152b is positioned on the rear passivation layer unit 190 and at least one rear electrode 151. As shown in FIG. 12, each rear electrode charge collector 152b may overlap portions of the adjacent rear reflection layer 161 a, and, in this instance, the rear electrode charge collector 152b may be positioned under the rear reflection layer 161 a or on the rear reflection layer 161 a.

The plurality of the rear electrode charge collectors 152a and 152b positioned on the at least one rear electrode 151 are formed by a screen printing method using paste containing silver (Ag), and so on, after the formation of the plurality of rear electrodes 151 and the rear reflection layer 161a (as shown in FIG. 11) or after the formation of the plurality of rear electrodes 151 and the rear passivation layer unit 190 (as shown in FIG. 12).

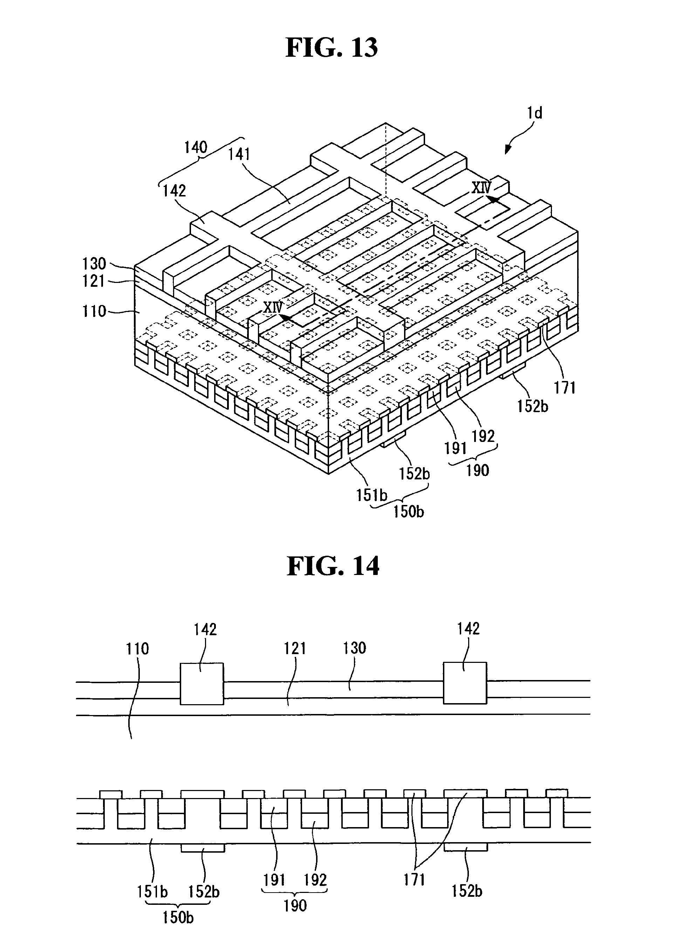

Next, in reference to FIGS. 13 to 16, solar cells according to other embodiments of the invention will be described.

The solar cells 1d and le have the same structure as the solar cell 1 in FIGS. 1 and 3A-3C except for a rear electrode unit 150b or 150c, respectively. Thereby, a detailed description of the same elements as shown in FIG. 1 and FIGS. 3A-3C is omitted.

In the solar cell 1d of FIGS. 13 and 14, a rear electrode 151b of a rear electrode unit 150b is connected to a back surface field region 171 and positioned on a rear passivation layer unit 190. Thereby, the rear electrode 151 b is substantially positioned on the entire rear surface of a substrate 110. In addition, a plurality of rear electrode charge collectors 152b of the rear electrode unit 150b face (or are aligned with) a plurality of front electrode charge collectors 142 and are positioned on the rear electrode 151b to extend parallel to the front electrode charge collectors 142.

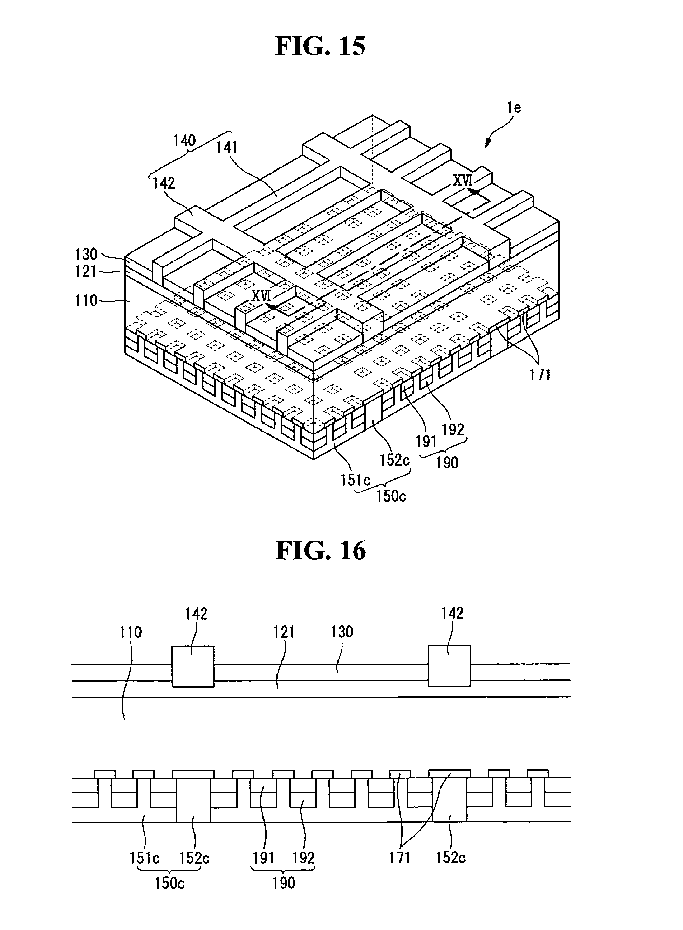

In the solar cell 1e of FIGS. 15 and 16, a rear electrode unit 150c includes a plurality of rear electrode charge collectors 152c and a plurality of rear electrodes 151 c. The plurality of rear electrode charge collectors 152c are directly connected to portions of the back surface field region 171, which face (or are aligned with) a plurality of front electrode charge collectors 142 to extend parallel to the front electrode charge collectors 142, while the rear electrodes 151c are connected to the other portions of the back surface field region 171 and positioned on the rear passivation layer unit 190. In this instance, the rear passivation layer unit 190 is positioned only under the rear electrodes 151 c.

In FIGS. 13 to 16, the rear electrodes 151 b and 151 c and the plurality of rear electrode charge collectors 152b and 152c are made of different materials from each other. As an example, the rear electrodes 151b and 151c may contain aluminum (Al) and the rear electrode charge collectors 152b and 152c may contain silver (Ag). The solar cells 1d and 1e do not include a separate rear reflection layer.

Methods for manufacturing the solar cells 1d and 1e are described below.

As shown in FIGS. 4A to 4D, after forming an emitter region 121, a back surface field region 171 and an anti-reflection layer 130, and then forming first and second rear passivation layers 191 and 192 on a substrate 110, portions of the second and first rear passivation layers 192 and 191 are removed to form a plurality of openings exposing portions of a rear surface of the substrate 110. In this instance, the plurality of openings may be formed by an etching process, an etching paste or lasers.

Next, for manufacturing the solar cell 1d of FIGS. 13 and 14, on the entire rear surface of the substrate 110, that is, on the rear surface exposing the plurality of openings and the rear passivation layer unit 190, a paste (aluminum paste) containing aluminum (Al) is applied and dried to form a rear electrode 151b. Then, a paste (silver paste) containing silver (Ag) is applied on the rear electrode 151b and dried, to form a plurality of rear electrode charge collectors 152b. Thereby, the rear electrode unit 150b including the rear electrode 151b and the plurality of rear electrode charge collectors 152b is completed. As shown in FIG. 4G, after applying a paste containing silver (Ag) on a front surface of the substrate 110, a thermal process is performed on the substrate 110 to form the front electrode unit 140 connected to the emitter region 121. The formation order of the rear electrode unit 150b and the front electrode unit 140 may be changed. However, instead of the formation of the plurality of openings in the rear passivation layer unit 190, the aluminum paste may be applied on the rear passivation layer unit 190 and dried, and then laser beans may be irradiated along the back surface field region 171 to connect portions of the rear electrode 151 b and the back surface field region 171.

In addition, after exposing the portions of the rear surface of the substrate 110 through the plurality of the openings in the rear passivation layer unit 190, processes for manufacturing the solar cell 1e shown in FIGS. 15 and 16 are as discussed below. That is, an aluminum paste is applied on the exposed portions through portions of the openings and on the rear passivation layer unit 190 and dried. Thereby, a plurality of rear electrodes 151 c are directly connected to portions of the back surface field region 171 and positioned on the rear passivation layer unit 190. Then, a silver paste is applied on the portions exposed through the remaining openings and dried, to form a plurality of rear electrode charge collectors 152c directly connected to the back surface field region 171. Next, as shown in FIG. 4G, after applying a paste containing silver (Ag) on a front surface of the substrate 110, a thermal process is performed on the substrate 110 to form the front electrode unit 140 connected to the emitter region 121. The formation order of the rear electrodes 151c, the plurality of rear electrode charge collectors 152c, and the front electrode unit 140 may be changed.

Thereby, the manufacturing process of the rear electrode units 150b and 150c becomes easy. Further, since silver (Ag) is used for manufacturing only the plurality of rear electrode charge collectors 152b and 152c, the manufacturing cost of the solar cells 1d and 1e decreases. In addition, a separate rear reflection layer is not necessary and thereby the manufacturing time and cost of the solar cells 1d and 1e are reduced.

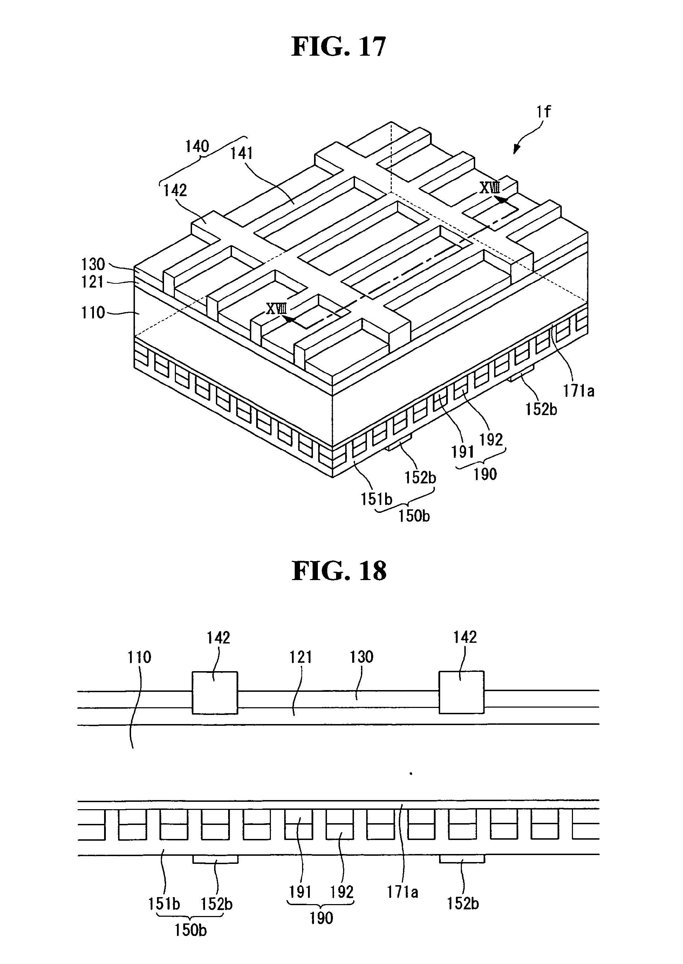

Referring to FIGS. 17 to 20, solar cells according to other embodiments of the invention will be described.

As compared with the solar cells 1d and 1e, the solar cells 1f and 1g shown in FIGS. 17 to 20 include a different back surface field region 171a. Thereby, the description of the same elements as the solar cells 1d and 1e is omitted.

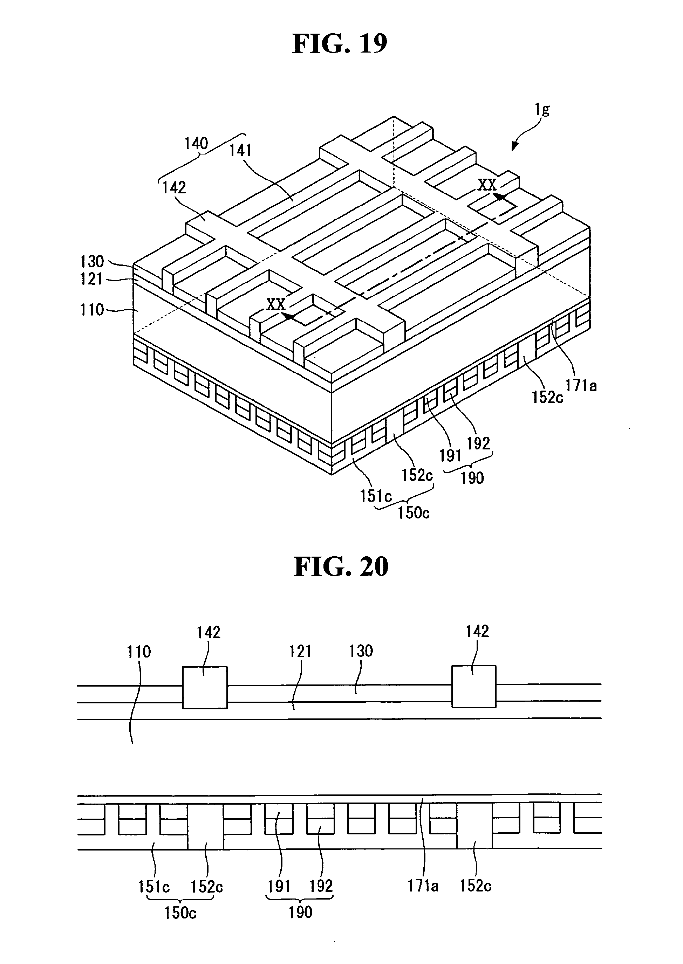

In the solar cells 1f and 1g in FIGS. 17 to 20, the back surface field region 171a is positioned at substantially the entire rear surface of the substrate 110 and rear electrodes 151 b and 151 c, and the rear electrodes 151 and 151 c and rear electrode charge collectors 152c as shown in FIGS.19 and 20 are partially connected to the back surface field region 171a. Thereby, since the back surface field region 171 a is positioned at the entire rear surface or at the rear surface of the substrate 110 except for an edge portion of the entire rear surface of the substrate 110, the back surface field region 171a is also positioned at the substrate 110 between adjacent portions of the rear electrodes 151b or 151c.

For forming the back surface field region 171a, based on the solar cell shown in FIGS. 4A or 5C, a back surface field region pattern 70 is applied on the entire rear surface of the substrate 110, and the back surface field region 171 a is formed at substantially the entire rear surface of the substrate 110 through a thermal process.

FIGS. 17 to 20, portions of the rear electrodes 151 b and 151c directly connected to the back surface field region 171a of the substrate 110 form matrix shapes (or lattice shapes), respectively.

However, alternatively, each of the rear electrodes 151b and 151c may have a stripe shape extending into a predetermined direction and may be directly connected to portions of the back surface field region 171a. Further, each of the rear electrodes 151b and 151c may be directly connected to portions of the back surface field regions 171a at a regular distance or an irregular distance. In this instance, each of the rear electrodes 151b and 151c is discontinuously connected to the portions of the back surface region 171a. For the structures of the rear electrodes 151b and 151c, the rear passivation layer unit 190 may includes a plurality of openings of stripe shapes or a plurality of openings disposed at the regular distance or the irregular distance. In this instance, the plurality of openings may be formed by an etching process using a mask, an etching paste, or laser beams. Further, an aluminum paste (and/or a sliver paste) is printed on the rear passivation layer unit 190 without the plurality of openings and dried, and then the laser beams are continuously or discontinuously irradiated on the aluminum paste (and/or the sliver paste) in a predetermined direction. Thereby, the rear electrodes 151b and 151c and the rear electrode charge collectors 152c are directly connected to the back surface field region 171a in a stripe shape or a discontinuous shape.

As examples, a rear size of the substrate exposed through the plurality of openings may be about 0.5% to 30% of the entire rear surface of the substrate. For example, when the plurality of openings are discontinuously formed in the rear passivation layer unit 190, a rear size of the substrate 110 exposed through the openings may be about 0.5% to 3% of the entire rear surface of the substrate. When the plurality of openings are formed in the stripe shape, a rear size of the substrate 110 exposed through the openings may be about 3% to 10% of the entire rear surface of the substrate. Further, when the openings are formed in the matrix shape (or a lattice shape), a rear size of the substrate 110 exposed through the opening may be about 10% to 30% of the entire rear surface of the substrate.

In the above examples, since the back surface field region 171a is positioned at substantially the entire rear surface of the substrate 110, the back surface field effect is improved to increase the efficiency of the solar cell. In addition, since the entire or most of the rear surface of the substrate is covered by the rear electrode 151 b or 151 c, a separate reflection layer is not necessary.

According to the embodiments, an area covered by the back surface field region 171 or 171a is about 0.5% to 100% of the entire rear surface of the substrate 110.

That is, when the back surface field region 171 is formed at the rear surface of the substrate 110 in a matrix shape (or a lattice shape), the minimum area covered by the back surface field region 171 may be about 0.5% of the entire rear surface of the substrate 110. The minimum area (about 0.5%) is more than that of a solar cell of a PERC (passivated emitter rear contact) structure which includes a rear passivation layer unit on the rear surface of the substrate 110 and back surface field regions locally formed at the rear surface of the substrate 110. When the back surface field region 171 is formed in a matrix shape (or a lattice shape), at least one of widths of horizontal portions and widths of vertical portions of the back surface field portion 171 may be changed, and further, the back surface field region 171a in the alternative example is positioned at the entire rear surface or substantially the entire rear surface of the substrate 110. Thereby, in the embodiments, an area covered by the back surface field region 171 or 171b may be about 0.5% to 100% of the entire rear surface of the substrate 110.

The above embodiments are described based on the p-type substrate 110. However, the embodiments may be applied to an n-type substrate. In this instance, the emitter region 121 is a p-type, the back surface field region 171 or 171a is an n-type. Further, the back surface field region pattern 70 for forming the back surface field region 171 or 171a contains impurities of the n-type instead of the p-type. The emitter region 121 is formed by a doping material containing a group III element impurity.

Although such solar cells 1 or 1a to 1g may be independently used, the plurality of solar cells 1 may be electrically connected in series or in parallel for greater efficient use and to form a solar cell module.

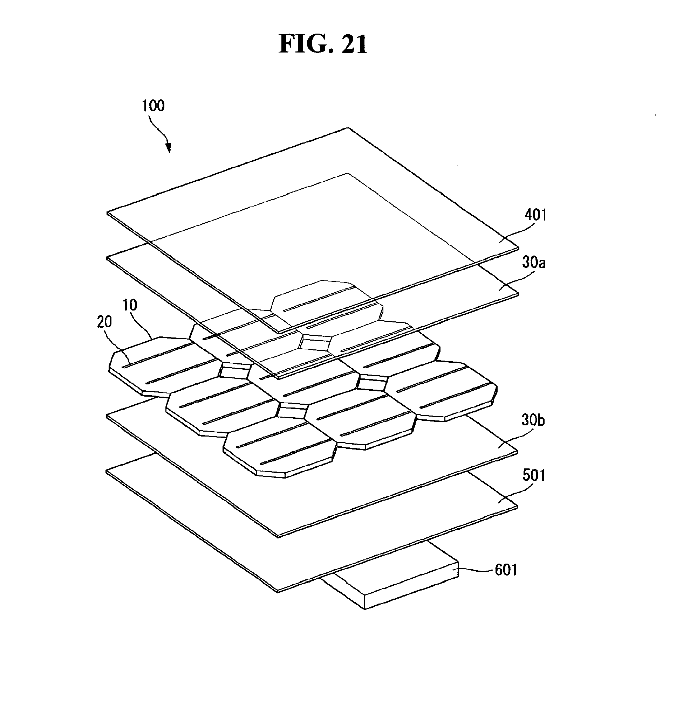

Next, a solar cell module using the solar cells 1 or 1a to 1g according to the example embodiments of the invention will be described with reference to FIG. 21.

Referring to FIG. 21, the solar cell module 100 according to this example embodiment includes a plurality of solar cells 10, interconnectors 20 electrically connecting the plurality of solar cells 10, protection films 30a and 30b for protecting the solar cells 10, a transparent member 401 positioned on the protection film (hereinafter, 'an upper protection film') 30a positioned on the light receiving surface of the solar cells 10, and a back sheet 501 disposed under the protection film (hereinafter, 'a lower protection film') 30b positioned on the opposite side of the light receiving surface on which light is not incident, a frame housing the above elements integrated through a lamination process, and a junction box 601 finally or ultimately collecting current and voltages generated by the solar cell 10.

The back sheet 501 prevents moisture from permeating or reaching the back surface of the solar cell module 100 and hence protects the solar cells 10 from an outside environment.

The back sheet 501 of this type may have a multi-layered structure, such as a layer for preventing permeation of moisture and oxygen, a layer for preventing chemical corrosion, and a layer having insulation characteristics, etc.

The upper and lower protection films 30a and 30b are integrated with the solar cells 10 during a lamination process, while being disposed on the upper and lower portions of the solar cells 10, to prevent the corrosion of metals caused by moisture permeation and protect the solar cell module 100 from an impact. Thereby the protection films 30a and 30b function as sealing members. These protection films 30a and 30b may be made of ethylene vinyl acetate (EVA) and the like.

The transparent member 401 positioned on the upper protection film 30a is made of tempered glass having high transmittance and excellent damage prevention function. At this point, the tempered glass may be a low iron tempered glass having a low iron content. The inner surface of the transparent member 40 may be embossed in order to increase a light scattering effect.

The interconnectors 20 may be conductive patterns patterned on the back sheet 501, etc., using a conductive material, or is called ribbons and may be conductive tapes (a thin metal plates) having string shapes and made of a conductive material.

The junction box 601 positioned under the back sheet 50 finally or ultimately collects current generated in the solar cells 10.

The frame protects the solar cells 10 from the outside environment or an impact. The frame may be made of a material preventing the corrosion or deformation due to the outside environment, such as aluminum coated by an insulating material, and may have a structure by which drainage, implementation and construction are easily performed.

The solar cell module 100 is manufactured by a method sequentially including testing the plurality of solar cells 1, electrically connecting in series or in parallel the tested solar cells 10 to one another using the interconnectors 20, successively disposing the back sheet 501, the lower passivation layer 30b, the solar cells 10, the upper passivation layer 30a, and the transparent member 401 from the bottom of the solar cell module 100 in the order named, performing the lamination process in a vacuum state to form an integral body of the components 1, 30a, 30b, 401, and 501, performing an edge trimming process, testing the completed solar cell module 100, and the like.

In embodiments of the invention, sides of the front electrodes 141, the front electrode charge collectors 142, the back surface field region 171 and/or the rear electrodes 151 that are stripe shape may be uneven or irregular, or may have even or irregular surfaces. Additionally, the front electrodes 141, the front electrode charge collectors 142, the back surface field region 171 and/or the rear electrodes 151 that are stripe shape may be formed in a lattice shape, respectively.

## Claims

1. A solar cell comprising:
a substrate of a first conductive type;
a first emitter region of a second conductive type opposite the first conductive type, and forming a p-n junction with the substrate;
a front electrode unit on a first surface of the substrate, and connected to the first emitter region;
a back surface field region of the first conductive type formed at a second surface of the substrate opposite the first surface, and having a lattice shape with a plurality of internal portions;
a rear passivation layer unit formed on the second surface; and
a rear electrode electrically connected to the substrate.

2. The solar cell of claim 1, wherein one or more of the plurality of internal portions are doped with impurities of the first type so that the one or more of the plurality of internal portions are a part of the back surface field region.

3. The solar cell of claim 2, wherein the back surface field region is formed on substantially the entire second surface of the substrate.

4. The solar cell of claim 1, wherein the rear electrode is formed of at least one stripe shape or in a lattice pattern.

5. The solar cell of claim 4, further comprising at least one rear electrode charge collector, and the at least one rear electrode charge collector is made of a different material from the rear electrode.

6. The solar cell of claim 5, wherein the at least one rear electrode charge collector is formed over the rear electrode.

7. The solar cell of claim 1, wherein the lattice shape of the back surface field region comprises a plurality of first portions having first widths and a plurality of second portions having second width that is greater than the first widths.

8. The solar cell of claim 7, further comprising a plurality of rear electrode charge collectors extending in a direction on the second surface of the substrate and connected to the back surface field region.

9. The solar cell of claim 8, wherein the rear electrode is directly in contact with the plurality of first portions of the back surface field region, and the plurality of rear electrode charge collectors are directly in contact with the plurality of second portions of the back surface field region.

10. The solar cell of claim 1, wherein the rear electrode is connected to the back surface field region through the rear passivation layer unit.

11. The solar cell of claim 10, further comprising a reflection layer positioned on the second surface of the substrate.

12. The solar cell of claim 11, wherein the reflection layer contains aluminum.

13. The solar cell of claim 11, wherein the reflection layer is made of an insulating material.

14. The solar cell of claim 11, wherein the reflection layer is positioned on the rear passivation layer unit positioned between adjacent portions of the rear electrode.

15. The solar cell of claim 11, wherein the reflection layer is positioned on the rear electrode and the rear passivation layer unit.

16. The solar cell of claim 11, wherein the rear passivation layer unit comprises a plurality of openings exposing portions of the second surface of the substrate on which the back surface field region is positioned.

17. The solar cell of claim 16, where a size of the second surface of the substrate exposed through the plurality of openings is about 0.5% to 30% of an entire second surface of the substrate.

18. The solar cell of claim 16, wherein the rear electrode is positioned on the second surface of the substrate exposed through the plurality of openings and the rear passivation layer unit.

19. The solar cell of claim 16, further comprising a plurality of rear electrode charge collectors directly positioned on the second surface of the substrate electrode and connected to the rear electrode.

20. The solar cell of claim 1, further comprising a second emitter region positioned at the second surface of the substrate.
